# FASCICULE DE BREVET EUROPEEN

(11) **EP 1 619 277 B1**
(45) Date de publication et mention de la délivrance du brevet: **13.04.2011**
(21) Numéro de dépôt: 05106613.2
(22) Date de dépôt: 19.07.2005
(51) Int. Cl.: C30B 29/60, H01L 29/76

(54) **Procédé de réalisation d'une structure dotée d'au moins une zone d'un ou plusieurs nanocristaux semi-conducteurs localisée avec précision**
Verfahren zur Herstellung einer Struktur mit wenigstens einer lagegenauen Zone von einem oder mehreren Halbleiter-Nanokristallen
Process for making a structure having at least one precisely positioned zone of one or several semiconductor nanocrystals

(30) Priorité: 20.07.2004 FR 0451589
(43) Date de publication de la demande: 25.01.2006
(73) Titulaire: Commissariat à l'Énergie Atomique et aux Énergies Alternatives, 75015 Paris (FR)
(72) Inventeur: Vinet, Maud, 38140 RIVES (FR); Barbe, Jean-Charles, 38100 GRENOBLE (FR); Mur, Pierre, 38920 CROLLES (FR); De Crecy, François, 38180 SEYSSINS (FR)
(74) Mandataire: Poulin, Gérard

(56) Documents cités:
- EP-A- 0 969 126
- EP-A- 1 229 590
- US-A1- 2002 086 483
- US-B1- 6 309 798
- MAZEN F ET AL: "Preferential nucleation of silicon nano-crystals on electron beam exposed SiO2 surfaces" MICROELECTRONIC ENGINEERING, ELSEVIER PUBLISHERS BV., AMSTERDAM, NL, vol. 73-74, juin 2004 (2004-06), pages 632-638, XP004564675 ISSN: 0167-9317
- BARON T ET AL: "Silicon quantum dot nucleation on Si3N4, SiO2 and SiOxNy substrates for nanoelectronic devices" JOURNAL OF CRYSTAL GROWTH, NORTH-HOLLAND PUBLISHING CO. AMSTERDAM, NL, vol. 209, no. 4, février 2000 (2000-02), pages 1004-1008, XP004198429 ISSN: 0022-0248
- NAKAJIMA: "Si quantum dot formation with low-pressure chemica vapor deposition" JP J. APPL.PHYS., vol. 35, 1996, pages L189-L191, XP002323294 JP

## Description

### DOMAINE TECHNIQUE

La présente invention est relative à un procédé de réalisation d'une structure ayant au moins une zone d'un ou plusieurs nanocristaux semi-conducteurs localisée avec précision sur un support.

Ces zones de nanocristaux sont des éléments entrant dans la composition de dispositifs électroniques tels que des mémoire Flash, des mémoires non volatiles ou des transistors à un électron. Ces zones forment des îlots dans lesquels sont confinés des électrons.

Ces zones de nanocristaux peuvent également être mises à profit pour utiliser les propriétés optiques des nanocristaux.

Ces nanocristaux sont préférentiellement en silicium, en germanium ou en alliage silicium germanium dans les premières applications citées afin d'assurer une compatibilité avec la technologie CMOS existante. De plus, pour remplir leur fonction à température ambiante, ces zones doivent avoir des dimensions maximum de quelques nanomètres, typiquement 5 nanomètres.

### ÉTAT DE LA TECHNIQUE ANTÉRIEURE

Il existe plusieurs familles de procédés employées actuellement pour obtenir des zones de nanocristaux semi-conducteurs.

La première famille utilise des procédés de dépôt chimique en phase vapeur qui permettent d'obtenir des zones de nanocristaux de taille requise comme décrit dans le document [1] dont les références se trouvent en fin de description.

Les couches déposées peuvent être obtenues par des techniques de dépôt en phase vapeur classiques : CVD (abréviation de chemical vapor deposition soit dépôt chimique en phase vapeur), PECVD (abréviation de plasma enhanced chemical vapor deposition soit dépôt chimique en phase vapeur assisté par plasma), LPCVD (abréviation de low pressure chemical vapor deposition soit dépôt chimique en phase vapeur à basse pression), RP-CVD (abréviation de reduced pressure chemical vapor deposition soit dépôt chimique en phase vapeur à pression réduite), co-pulvérisation connue sous la dénomination anglaise de co-sputtering.

Une autre famille de méthodes est dite par croissance. Ces méthodes sont basées sur la croissance de cristaux à partir d'une phase gazeuse par des techniques de type CVD. On peut se référer au document [2] dont les références se trouvent en fin de description. Le contrôle de la vitesse de croissance permet de contrôler le mode de croissance à deux dimensions ou trois dimensions. Les dépôts chimiques en phase gazeuse dans un réacteur industriel permettent aujourd'hui de contrôler la densité des nanocristaux (typiquement entre 10⁹/cm² et 1,5.10¹²/cm pour du silicium) ainsi que leur diamètre (typiquement compris entre 3 nm et 30 nm).

Des travaux récents montrent qu'il est possible de contrôler de manière indépendante la densité et le diamètre des nanocristaux par l'utilisation d'un substrat spécifique avec des germes de nucléation qui vont former des sites de croissance préférentiels pour les nanocristaux.

Le document [3] dont les références se trouvent en fin de description précise qu'en effectuant un traitement superficiel de la couche (en oxyde de silicium) sur laquelle vont croître les nanocristaux par irradiation électronique, on peut former ces sites en désorbant localement de l'oxygène.

Les méthodes qui n'utilisent pas les sites de germination ne permettent pas de contrôler l'orientation cristallographique des nanocristaux formés. Toutes ces méthodes ne permettent que très difficilement la mise en place d'électrodes de contrôle de la même manière que cela été mentionné plus haut.

Une autre famille dite par précipitation, est basée sur la préparation d'une couche ou matrice dont la composition à base de silicium est dite sous-stoechiométrique. Une telle couche peut être du SiOₓ où x est strictement inférieur à 2. La forme stoechiométrique du dioxyde de silicium est obtenue pour x égal 2.

Lors du dépôt, la stoechiométrie de la couche est ajustée en fonction des concentrations relatives des espèces gazeuses mises en jeu.

Ces couches peuvent être également obtenues par implantation ionique. On implante du silicium dans une couche de silice amorphe SiO₂ de manière à l'enrichir localement. C'est directement la quantité implantée qui permet de contrôler l'écart de stoechiométrie.

Les couches sont ensuite recuites à haute température (typiquement entre 600°C et 1250°C) et des nanocristaux de silicium se forment, ils sont entourés de silice stoechiométrique. Un contrôle indépendant de la densité des nanocristaux et de leur rayon peut être obtenu.

La couche de composition sous-stoéchiométrique peut également être obtenue par bombardement électronique à haute énergie (quelques keV) d'une couche de base en silice amorphe SiO₂ ou en nitrure de silicium Si₃N₄. L'irradiation permet de créer des cristaux de silicium au sein d'une matrice d'oxyde ou de nitrure de silicium. On peut se référer au document [4] dont les références sont précisées en fin de description.

Ces procédés présentent de nombreux inconvénients. Les procédés autres que l'irradiation électronique ne permettent pas de contrôler la position des nanocristaux puisqu'ils se forment au niveau de défauts tels qu'un agrégat d'atomes de silicium ou une impureté par exemple, dans la couche de base. La répartition et la localisation de ces sites dits de nucléation sont pour la plus part des cas aléatoires. Lorsque l'on veut utiliser ces nanocristaux pour réaliser des transistor à un électron, il faut placer de part et d'autre de ces zones de nanocristaux des électrodes de commande qui sont préférentiellement situées dans le plan dans lequel ces nanocristaux sont formés. Les électrodes ne peuvent être mises en place que très difficilement. Cela requiert un contrôle très pointu de l'auto-alignement lors des étapes technologiques permettant de construire ces électrodes de contrôle.

Aucune de ces méthodes ne permet le contrôle de l'orientation cristallographique des nanocristaux formés. Cette orientation est a priori aléatoire et n'a aucune raison d'être corrélée d'un nanocristal à son ou ses voisins.

Dans tous les cas les nanocristaux sont créés au sein d'une matrice isolante de silice amorphe ou de nitrure de silicium, cette matrice isolante ne présentant pas nécessairement d'intérêt fonctionnel.

La dernière famille de procédé est de type gravure.

On peut utiliser des résines dont les propriétés sont modifiées par irradiation sous faisceau d'électrons. La résine insolée est développée ce qui permet de créer des motifs géométriques de taille nanométrique dans la résine, et donc dans la couche sous-jacente après gravure en s'appuyant sur la résine utilisée comme un masque. La résine est ensuite ôtée. La couche sous-jacente peut être en silicium, en germanium ou en alliage silicium germanium.

On peut réaliser une insolation directe par faisceau d'électrons d'un film obtenu par dépôt en phase liquide assisté par une rotation de la plaquette (connu sous la dénomination anglaise de spin-coating ou dépôt à la tournette) à partir d'une solution contenant un métal ou un métal de transition des groupes 4 à 12 du tableau de Mendeleïev comme décrit dans le document [5] dont les références se trouvent en fin de description.

On peut réaliser également une gravure directe d'un motif dans un film précurseur (aluminium) et un bombardement ionique du film précurseur gravé comme décrit dans le document [6] dont les références se trouvent en fin de la description.

Ces méthodes de gravure pallient en partie aux inconvénients des méthodes précédentes puisqu'elles permettent de définir et de localiser les zones de nanocristaux. Toutefois, pour ce qui concerne les deux premières méthodes, elles nécessitent le couchage d'une résine ou d'un précurseur, son insolation et son développement. Elles sont donc assez coûteuses et posent des problèmes de contamination organique. Quant à la technique de gravure par bombardement ionique, elle nécessite l'emploi d'un faisceau ionique focalisé qui n'est pas un outil standard en production.

Il est aussi possible d'utiliser les techniques de sonde locale associée à un microscope à force atomiques ou un microscope à effet tunnel pour localiser, positionner et prendre des contacts électriques sur les nanocristaux. Cette méthode est une méthode de déplacement d'objets localisés qui nécessite l'intervention d'un opérateur pour positionner le ou les nanocristaux aux endroits souhaités. Cette méthode n'est pas intégrable dans une filière industrielle comme celle de la technologie CMOS.

### EXPOSÉ DE L'INVENTION

La présente invention a justement comme but de proposer un procédé de réalisation d'une structure dotée d'au moins une zone d'un ou plusieurs nanocristaux semi-conducteurs qui ne présente pas les inconvénients mentionnés ci dessus.

Un but est en particulier de localiser avec grande précision la zone de nanocristaux au sein de la structure en maîtrisant l'orientation cristallographique des nanocristaux formés.

Un autre but de l'invention est de réaliser la structure à bas coût.

Un autre but de l'invention, dans le cas où la structure comporte au moins une électrode voisine de la zone de nanocristaux et dans le plan de celle-ci, est de réaliser aisément cette électrode.

Un autre but de l'invention est de proposer un procédé compatible avec l'intégration dans une filière industrielle comme celle de la technologie CMOS.

Encore un autre but de l'invention est de s'affranchir d'éventuelles pollutions organiques liées aux résines ou autres précurseurs.

Pour atteindre ces buts l'invention propose d'exploiter le phénomène de démouillage d'un film semi-conducteur à haute température. Ce phénomène de démouillage qui consiste en une rétraction localisée du film semi-conducteur, à haute température, pour former des gouttelettes comme le font les liquides, est un phénomène connu qui apparaît pendant l'enchaînement technologique nécessaire à la fabrication de composants de type MOS. Actuellement cette rétraction est considérée comme un inconvénient qu'il faut combattre pendant la fabrication des composants.

Plus précisément la présente invention concerne un procédé de réalisation d'une structure dotée d'au moins une zone d'un ou plusieurs nanocristaux semi-conducteurs. Il consiste :
- à insoler avec un faisceau d'électrons au moins une zone d'un film semi-conducteur reposant sur un support électriquement isolant, la zone insolée contribuant à définir au moins une zone de démouillage du film,
- à recuire le film à haute température de manière à ce que la zone de démouillage se rétracte en donnant la zone d'un ou plusieurs nanocristaux.

Il est avantageux de doper, au moins la zone à insoler du film, avant l'insolation pour modifier les propriétés de transport par diffusion en surface du film semi-conducteur et/ou dans son volume et/ou les propriétés de mouillage entre le film et le support.

Il peut être avantageux de doper au moins une zone entourant la zone à insoler de manière à tenir compte d'une extension latérale de la zone de démouillage.

La température de recuit peut être comprise typiquement entre environ 650°C et 1250°C.

Le film semi-conducteur et/ou le support électriquement isolant peuvent être monocouches ou multicouches.

Pour réduire la température de recuit, le film semi-conducteur peut être contraint.

Le film semi-conducteur peut être réalisé à base de silicium et/ou de germanium.

Le support électriquement isolant peut être réalisé en oxyde de silicium ou en nitrure de silicium au moins au niveau de l'interface avec le film semi-conducteur.

Il est possible de conduire simultanément l'étape d'insolation et l'étape de recuit.

L'étape de recuit peut avoir lieu au sein d'un microscope électronique.

L'étape de recuit peut avoir lieu sous atmosphère neutre ou réductrice.

La zone d'insolation peut comporter une ou plusieurs parties, lorsqu'il y en plusieurs, elles peuvent être accolées ou séparées les unes des autres.

Ces parties peuvent être ponctuelles.

Le faisceau d'électrons peut être balayant pour réaliser l'insolation.

Le film peut être pleine plaque ou au contraire délimité en au moins un motif.

Le film en motif peut réaliser, à l'issu de l'étape de recuit, en plus de la zone de nanocristaux, au moins une électrode destinée à coopérer avec la zone de nanocristaux.

L'électrode et la zone de nanocristaux sont séparées par une zone du support formant une jonction tunnel.

La structure peut correspondre à une source, un canal et un drain d'un transistor à un électron.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A à 1C représentent des étapes d'un premier exemple de procédé selon l'invention ;
Les figures 2A à 2D représentent des étapes d'un second exemple de procédé selon l'invention, la figure 2E représentant schématiquement un transistor de type SET obtenu par le procédé de l'invention ;
La figure 3 représente une photographie d'une zone de nanocristaux obtenue avec le procédé selon l'invention.

Ces différentes possibilités exposées dans la description qui suit doivent être comprises comme n'étant pas exclusives les unes des autres.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

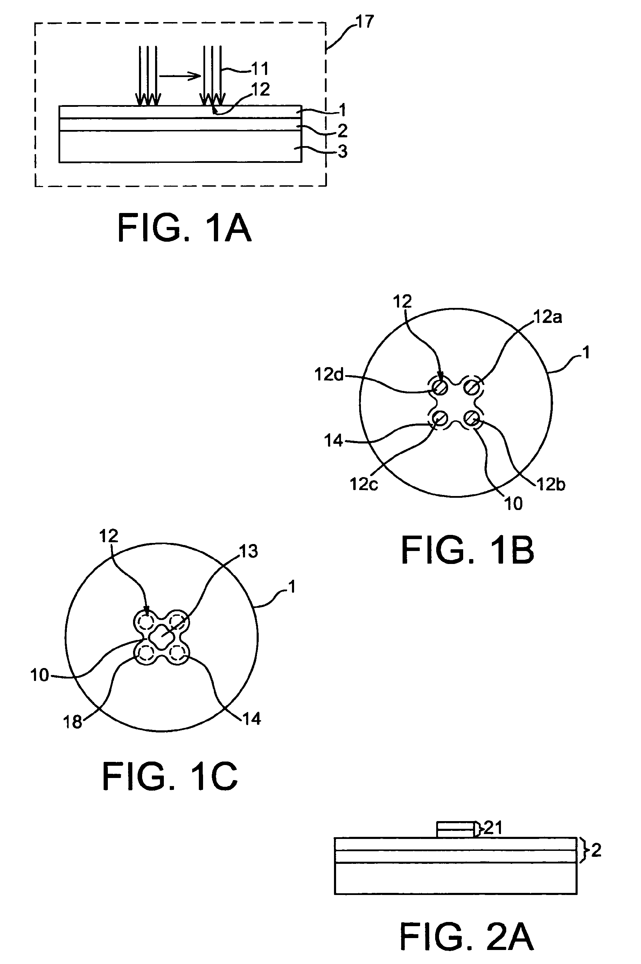

On va maintenant décrire les étapes de réalisation d'une structure dotée d'au moins une zone d'un ou plusieurs nanocristaux semi-conducteurs selon l'invention. On se réfère aux figures 1A, 1B, 1C.

On part d'un film mince 1 en matériau semi-conducteur qui repose sur un support 2 en matériau isolant électriquement (figure 1A).

La référence 3, dans l'exemple décrit, représente un substrat semi-conducteur sur isolant, par exemple SOI (abréviation de silicon on insulator soit silicium sur isolant). Dans ce cas, le film semi-conducteur 1 est formé de la couche semi-conductrice la plus mince du substrat SOI et le support 2 est la couche isolante placée entre les deux couches semiconductrices du substrat SOI.

Le film semi-conducteur 1 peut être monocouche. Il peut s'agir par exemple d'un film de silicium ou de germanium ou de silicium-germanium.

En variante le film semi-conducteur peut être multi-couche. Il peut s'agir par exemple d'un empilement de germanium sur silicium, de silicium-germanium sur du silicium ou tout autre empilement compatible de ces matériaux. Sur la figure 1A, on a illustré un film monocouche et sur la figure 2A un film multicouche.

Le support diélectrique 2 peut être en oxyde de silicium ou en nitrure de silicium par exemple au moins au niveau de l'interface avec le film semi-conducteur 1. Le support 2 peut également être monocouche (figure 1A) ou multicouche (figure 2A). Lorsqu'il est multicouche, il peut être par exemple formé d'un empilement de couches d'oxyde de silicium et de nitrure de silicium.

On insole le film 1 sur au moins une zone 12 par un faisceau d'électrons 11. Cette insolation permet de maîtriser un lieu à partir duquel un phénomène de démouillage du film 1 va pouvoir se produire. L'insolation a pour fonction d'initier une agglomération du film 1, cette agglomération s'achèvera au cours d'une étape de recuit décrite plus loin. L'interface entre le film mince 1 et le support 2 va être modifiée par l'interaction électrons matière. La zone d'insolation 12 va conditionner la définition d'une zone de démouillage 10 du film 1. La zone de démouillage 10 peut s'étendre au-delà de la zone d'insolation 12. La zone de démouillage 10 va en se rétractant entraîner la rupture du film 1 et donner ainsi la zone d'un ou plusieurs nanocristaux 13.

La zone de démouillage 10 possède une extension latérale 14 par rapport à la zone d'insolation 12. Sur la figure 1B, l'extension latérale 14 est illustrée. Cette extension latérale peut être minimisée par exemple par une implantation préalable d'espèces dopantes comme on le verra ultérieurement. Cela réduit localement la diffusion.

L'insolation se fait à l'aide de moyens 17 aptes à produire le faisceau d'électrons 11 tels un microscope électronique à balayage ou non, ou tout autre instrument produisant un faisceau d'électrons 11. Ces moyens sont schématisés sur la figure 1A. La zone d'insolation 12 peut s'étendre sur une ou plusieurs parties 12a, 12b, 12c, 12d. Ces parties peuvent être ponctuelles comme sur la figure 1C, c'est-à-dire correspondre à la section du faisceau d'électrons 11. Lorsqu'il y a plusieurs parties, elles peuvent être accolées ou bien séparées les unes des autres. Le faisceau d'électrons 11 peut avoir un diamètre de quelques nanomètres (typiquement 3 nanomètres) et pour insoler une surface plus grande que celle du faisceau électronique, on peut être amené à balayer le film 1 avec le faisceau d'électrons 11 comme sur la figure 1A. Le faisceau d'électrons 11 peut parcourir un chemin déterminé et pas forcément continu pour définir une ou plusieurs zones de démouillage 10.

Le film semi-conducteur 1 sur son support 2 est soumis à un recuit à haute température typiquement comprise entre environ 650°C et 1250°C. Lors de cette étape, la majeure partie du démouillage se produit. Le film 1 de la zone de démouillage 10 se rétracte et s'agglomère en formant la zone d'un ou plusieurs nanocristaux 13. Cette zone de nanocristaux 13 est souvent appelée quantum dot dans la littérature anglosaxonne soit boîte quantique.

Le recuit en fait active la diffusion de surface, c'est-à-dire active la mobilité des atomes de la zone de démouillage 10. Cette mobilité a été autorisée par la fragilisation de l'interface entre le film 1 et le support 2 engendrée l'insolation.

La taille de la section du faisceau d'électrons 11 influence directement la taille minimale de la zone de nanocristaux 13. Plus le faisceau d'électrons 11 sera fin, plus la zone de nanocristaux 13 sera petite. Par contre, dans le cas où la zone d'insolation 12 est étendue, la taille de la section du faisceau d'électrons 11 n'influence pas celle de la zone de nanocristaux 13 puisque le faisceau d'électrons est balayant.

Le faisceau d'électrons 11 aura une énergie de l'ordre de 500 eV pour un film d'environ 10 nanomètres d'épaisseur. Cette énergie peut être optimisée en fonction de l'épaisseur du film. En effet, la profondeur de pénétration des électrons dans la matière du film 1 est proportionnelle à E^{x} avec E énergie des électrons incidents et x voisin de 1,6. Plus le film 1 est épais plus l'énergie requise pour atteindre l'interface entre le film 1 et le support 2 est élevée.

Le problème du positionnement précis des nanocristaux de la zone de nanocristaux est résolu spatialement avec la précision de positionnement de la zone d'insolation 12 et donc la précision des moyens aptes à produire le faisceau d'électrons 11. L'orientation cristallographique des cristaux est maîtrisée pendant l'agglomération, elle correspond à l'orientation cristallographique du film 1 de départ.

L'étape de recuit peut se faire de préférence sous une atmosphère neutre voire réductrice pour limiter la croissance d'un oxyde à la surface du film mince. Un tel oxyde pourrait en effet totalement annuler toute diffusion de matière à la surface du film. L'atmosphère neutre peut être azotée. L'atmosphère réductrice peut être hydrogénée ou chlorée par exemple.

L'étape d'insolation et celle de recuit peuvent être conduites simultanément et se faire par exemple in situ dans un microscope électronique à balayage.

Il est avantageux de prévoir avant l'étape d'insolation, une étape préliminaire de dopage par implantation d'espèces dopantes dans le film 1 d'au moins la zone d'insolation 12 et/ou d'au moins une zone 18 entourant la zone d'insolation 12. La zone 18 entourant la zone d'insolation peut ne pas venir en contact avec la zone d'insolation 12. Les espèces dopantes peuvent être du bore, du phosphore, de l'arsenic, du fluorure de bore BF₂ par exemple. Ce dopage permet un meilleur contrôle de l'extension 14 de la zone de démouillage 10 par rapport à la zone d'insolation 12. Ce dopage modifie les propriétés de diffusion et/ou de mouillage entre le film 1 et le support 2. Cette étape permet de maîtriser la vitesse de démouillage et donc l'extension latérale 14 de la zone de démouillage 10 pour une durée de recuit donnée.

L'étape de recuit a une durée de quelques minutes (typiquement deux minutes) mais en fonction de l'épaisseur du film 1, du dopage, de la température et de l'extension 14 souhaitée, le temps peut être adapté.

Une variante avantageuse est d'utiliser un film mince contraint, c'est-à-dire un film dont le paramètre de maille diffère de celui du même film libre de tout effort extérieur. Il peut s'agir de silicium, de germanium ou de silicium germanium contraint.

Dans ce cas, la perte de cohésion de l'interface lors de l'insolation, va engendrer un gradient d'énergie élastique qui va directement influencer la vitesse de démouillage du film 1 car ce terme de gradient est un terme moteur dans le flux de matière. Typiquement le temps caractéristique de migration des atomes par diffusion en surface du film contraint 1 est inversement proportionnel à ξ⁸ où ξ représente l'énergie élastique du film. La vitesse de démouillage va être extrêmement sensible à l'état de contrainte du film et l'état de contrainte du film apparaît donc comme un paramètre permettant de contrôler la cinétique et d'avoir une certaine liberté sur la température de recuit. Plus le film est contraint, plus on peut travailler à basse température pour une cinétique donnée.

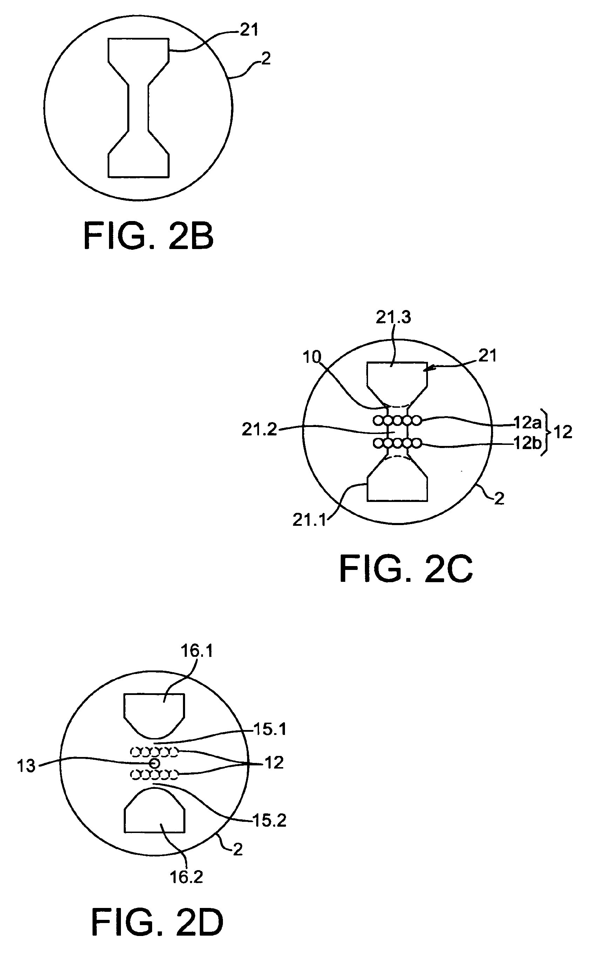

Sur les figures 1A à 1C, le film 1 est un film pleine plaque, cela signifie qu'il recouvre en totalité le support 2. En variante, ce film 21 peut être délimité en au moins un motif. Sa superficie est plus petite que celle du support 2, ce dernier est apparent comme illustré sur les figures 2A, 2B.

En se référent aux figures 2A à 2D, on va décrire un nouvel exemple de procédé de réalisation d'une structure dotée d'au moins une zone d'un ou plusieurs nanocristaux selon l'invention. Cette structure est une partie d'un transistor à un électron (SET).

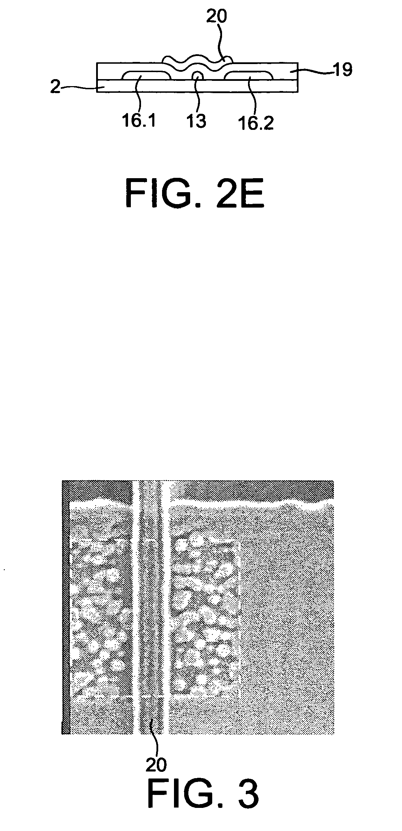

Un tel transistor comporte une zone d'un ou plusieurs nanocristaux qui est un site de stockage contrôlé d'électrons (canal). L'accès à cette zone de nanocristaux est réalisée par deux électrodes (drain, source) qui s'étendent dans le plan de la zone de nanocristaux. Entre la zone de nanocristaux et chacune des électrodes se trouve une jonction tunnel. Sur la figure 2D seuls sont visibles la source, le drain et le canal du transistor à un électron. Sur la figure 2E, une électrode de grille 20 a été ajoutée.

Dans la configuration des figures 2, il est possible de doper le film 21 en motif dans sa totalité. Sur la figure 2C, la zone de démouillage 10 est délimitée avec des pointillés et la zone d'insolation 12 est illustrée. La zone d'insolation 12 est en deux parties 12a, 12b, ces deux parties ne sont pas ponctuelles, elles sont allongées et traversent le film 21 en le divisant en trois tronçons successifs 21.1 à 21.3, l'un médian 21.2 et les deux autres extrêmes 21.1, 21.3. La zone d'insolation 12 ne doit pas nécessairement s'étendre au-delà du film 21 en motif mais cela peut permettre de palier à un éventuel manque de précision de positionnement lors de l'insolation.

Après l'étape de recuit (figure 2D), le tronçon médian 21.2 du film 21 s'est rétracté, il forme la zone d'un ou plusieurs nanocristaux 13. Les deux tronçons extrêmes 21.1, 21.3 ne se sont rétractés que localement à partir du tronçon médian 21.2. Ils forment les électrodes 16.1, 16.2 de commande (drain, source). Entre la zone de nanocristaux 13 et chacune des deux électrodes 16.1, 16.2, le matériau diélectrique présent du support 2 va former les jonctions tunnel 15.1, 15.2.

On se réfère à la figure 2E. Pour former le transistor à un électron, il faut ensuite encapsuler la structure dans un matériau diélectrique 19 (par exemple de l'oxyde de silicium thermique ou de l'oxyde d'hafnium) et doter la structure d'une grille 20 obtenue par exemple par un enchaînement connu de l'homme de métier dépôt/photolithographie/gravure de polysilicium ou tout autre empilement connu pour la réalisation d'une grille (par exemple TiN/Tungstène....). Il faudra également prévoir des reprises de contact sur les éléments actifs de ce transistor à un électron. Ces dernières ne sont pas réprésentées sur la figure 2E.

Puisque les deux électrodes 16.1, 16.2 ont été formées en même temps que la zone de nanocristaux 13, elles sont auto-alignées avec elle.

En procédant ainsi, on est capable de maîtriser l'endroit à partir duquel le démouillage va être initié et l'amplitude de l'extension latérale sur lequel le démouillage va s'étendre. Le phénomène de démouillage qui posait problème par le passé est ici mis à profit pour contrôler la position des nanocristaux.

La figure 3 illustre une photographie de la zone de nanocristaux obtenue par le procédé selon l'invention. Le film en silicium repose sur un support en oxyde de silicium d'un substrat SOI. Il a une épaisseur de 10 nanomètres. Il a été dopé avec du fluorure de bore BF₂ (5.10¹⁴ at/cm² avec une énergie de 3 keV). Il a été insolé avec un faisceau d'électrons de 0, 5 KeV dans la zone en pointillés. Les agglomérats de silicium, c'est à dire la zone de nanocristaux, ont été obtenus après recuit à 650°C pendant 2 minutes. La taille des nanocristaux formés est de l'ordre de 25 nanomètres et leur densité de l'ordre de 10⁹/cm².

Une grille 20 a été déposée en travers de la zone de nanocristaux après le démouillage.

Le procédé ainsi décrit est totalement compatible avec la filière CMOS actuelle. Il n'est pas nécessaire de disposer d'appareils spécifiques à faisceau ionique focalisé par exemple.

Il n'y a aucun risque de pollution organique liée aux résines ou autres précurseurs.

Bien que plusieurs modes de réalisation de la présente invention aient été représentés et décrits de façon détaillée, on comprendra que différents changements et modifications puissent être apportés sans sortir du cadre de l'invention.

### DOCUMENTS CITES :

**[1]** Silicon quantum dot nucleation on Si₃N₄ and SiOₓN_{y} substrates for nanoeletronic devices, T. Baron, F. Martin, P. Mur, C. Wyon, M. Dupuy, Journal of Crystal Growth 209 (2000) pages 1004-1008.
**[2]** Si quantum dot formation with low-pressure chemical vapor deposition, A. Nakajimi, Y. Sugita, K. Kawamura, H. Tomita, N. Yokoyama, Japan Journal of Applied Physics, Vol. 35 (1996) pages 189 à 191.
**[3]** Preferential nucleation of silicon nano-crystals on electron-beam exposed SiO₂ surfaces, F. Mazen, L. Mollard, T. Baron, S. Decossas, J.M. Hartmann, Microelectronics Engineering 73-74 (2004), pages 632-638
**[4]** EP-A-0 969 126
**[5]** US-B-6 309 798.
**[6]** US-A-2002/0086483.

## Revendications

1. Procédé de réalisation d'une structure dotée d'au moins une zone d'un ou plusieurs nanocristaux semi-conducteurs (13), **caractérisé en ce qu'**il consiste :
- à insoler avec un faisceau d'électrons (11) au moins une zone (12) d'un film semi-conducteur (1) reposant sur un support électriquement isolant (2), la zone insolée (12) contribuant à définir au moins une zone de démouillage (10) du film (1),
- à recuire le film (1) à haute température de manière à ce que la zone de démouillage (10) se rétracte en donnant la zone d'un ou plusieurs nanocristaux (13).

2. Procédé selon la revendication 1, **caractérisé en ce qu'**il consiste à doper au moins la zone à insoler (12) du film (1) avant l'insolation.

3. Procédé selon l'une des revendications 1 ou 2, **caractérisé en ce qu'**il consiste à doper au moins une zone (18) entourant la zone à insoler (12).

4. Procédé selon l'une des revendications 1 à 3, **caractérisé en ce que** la température de recuit est comprise entre environ 650°C et 1250°C.

5. Procédé selon l'une des revendications 1 à 4, **caractérisé en ce que** le film semi-conducteur (1) et/ou le support électriquement isolant (2) sont monocouches ou multicouches.

6. Procédé selon l'une des revendications 1 à 5, **caractérisé en ce que** le support électriquement isolant (2) est en oxyde de silicium et/ou en nitrure de silicium au moins au niveau d'une interface avec le film semi-conducteur (1).

7. Procédé selon l'une des revendications 1 à 6, **caractérisé en ce que** le film semi-conducteur (1) est contraint.

8. Procédé selon l'une des revendications 1 à 7, **caractérisé en ce que** le film semi-conducteur (1) est réalisé à base de silicium et/ou de germanium.

9. Procédé selon l'une des revendications 1 à 8, **caractérisé en ce que** l'étape d'insolation et l'étape de recuit sont conduites simultanément.

10. Procédé selon la revendication 9, **caractérisé en ce que** l'étape de recuit a lieu au sein d'un microscope électronique (17).

11. Procédé selon l'une des revendications 1 à 10, **caractérisé en ce que** l'étape de recuit a lieu sous atmosphère neutre ou réductrice.

12. Procédé selon l'une des revendications 1 à 11, **caractérisé en ce que** la zone d'insolation (12) comporte une ou plusieurs parties (12a, 12b, 12c, 12d), lorsqu'il y a plusieurs parties, ces dernière sont séparées les unes des autres ou accolées.

13. Procédé selon la revendication 12, **caractérisé en ce que** ces parties sont ponctuelles.

14. Procédé selon l'une des revendications 1 à 13, **caractérisé en ce que** le faisceau d'électrons (11) est balayant.

15. Procédé selon l'une des revendications 1 à 14, **caractérisé en ce que** le film (1) est pleine plaque.

16. Procédé selon l'une des revendications 1 à 14, **caractérisé en ce que** le film (21) est délimité en au moins un motif.

17. Procédé selon la revendication 16, **caractérisé en ce que** le film en motif (21) réalise, à l'issue de l'étape de recuit, en plus de la zone de nanocristaux (13) au moins une électrode (16.1, 16.2) destinée à coopérer avec la zone de nanocristaux (13).

18. Procédé selon la revendication 17, **caractérisé en ce que** l'électrode (16.1, 16.2) et la zone de nanocristaux (13) sont séparées par une zone du support formant une jonction tunnel (15.1, 15.2).

19. Procédé selon l'une des revendications 17 ou 18, **caractérisé en ce que** la structure correspond à une source, un canal et un drain d'un transistor à un électron.

## Claims

1. Method for forming a structure provided with at least one zone of one or several semiconductor nanocrystals (13), **characterised in that** it consists in:
- exposing with a beam of electrons (11) at least one zone (12) of a semiconductor film (1) liying on an electrically insulating support (2), the exposed zone (12) contributing to defining at least one dewetting zone (10) of the film (1),
- annealing the film (1) at high temperature in such a way that the dewetting zone (10) retracts giving the zone of one or several nanocrystals (13).

2. Method according to claim 1, **characterised in that** it consists in doping at least the zone to be exposed (12) of the film (1) before the exposure.

3. Method according to one of claims 1 or 2, **characterised in that** it consists in doping at least one zone (18) surrounding the zone to be exposed (12).

4. Method according to one of claims 1 to 3, **characterised in that** the annealing temperature is between around 650°C and 1250°C.

5. Method according to one of claims 1 to 4, **characterised in that** the semiconductor film (1) and/or the electrically insulating support (2) are monolayers or multilayers.

6. Method according to one of claims 1 to 5, **characterised in that** the electrically insulating support (2) is in silicon oxide and/or in silicon nitride at least at the level of an interface with the semiconductor film (1).

7. Method according to one of claims 1 to 6, **characterised in that** the semiconductor film (1) is strained.

8. Method according to one of claims 1 to 7, **characterised in that** the semiconductor film (1) is formed from silicon and/or germanium.

9. Method according to one of claims 1 to 8, **characterised in that** the exposure step and the annealing step are carried out simultaneously.

10. Method according to claim 9, **characterised in that** the annealing step takes place within an electronic microscope (17).

11. Method according to one of claims 1 to 10, **characterised in that** the annealing step takes place under a neutral or reducing atmosphere.

12. Method according to one of claims 1 to 11, **characterised in that** the exposure zone (12) comprises one or several parts (12a, 12b, 12c, 12d), when there are several parts, said parts are separated from each other or placed side by side.

13. Method according to claim 12, **characterised in that** said parts are point shaped.

14. Method according to one of claims 1 to 13, **characterised in that** the electron beam (11) is scanning.

15. Method according to one of claims 1 to 14, **characterised in that** the film (1) is full wafer.

16. Method according to one of claims 1 to 14, **characterised in that** the film (21) is delimited into at least one pattern.

17. Method according to claim 16, **characterised in that** the patterned film (21) forms, at the end of the annealing step, in addition to the zone of nanocrystals (13), at least one electrode (16.1, 16.2) intended to cooperate with the zone of nanocrystals (13).

18. Method according to claim 17, **characterised in that** the electrode (16.1, 16.2) and the zone of nanocrystals (13) are separated by a zone of the support forming a tunnel junction (15.1, 15.2).

19. Method according to one of claims 17 or 18, **characterised in that** the structure corresponds to a source, a channel and a drain of a single electron transistor.

## Patentansprüche

1. Verfahren zur Herstellung einer Struktur, die mit wenigstens einer Zone mit einem oder mehreren Halbleiter-Nanokristallen (13) versehen ist, **dadurch gekennzeichnet, dass** es umfasst:
- Bestrahlen wenigstens einer Zone (12) eines Halbleiterfilms (1), der auf einem elektrisch isolierenden Träger (2) ruht, mit einem Elektronenstrahl (11), wobei die bestrahlte Zone (12) dazu beiträgt, wenigstens eine Entnetzungszone (10) des Films (1) zu definieren,
- Tempern des Films (1) bei hoher Temperatur derart, dass sich die Entnetzungszone (10) zusammenzieht, wobei sich die Zone von einem oder mehreren Nanokristallen (13) ergibt.

2. Verfahren nach Anspruch 1, **dadurch gekennzeichnet, dass** es ein Dotieren wenigstens der zu bestrahlenden Zone (12) des Films (1) vor der Bestrahlung umfasst.

3. Verfahren nach einem der Ansprüche 1 oder 2, **dadurch gekennzeichnet, dass** es ein Dotieren wenigstens einer Zone (18) umfasst, die die zu bestrahlende Zone (12) umgibt.

4. Verfahren nach einem der Ansprüche 1 bis 3, **dadurch gekennzeichnet, dass** die Tempertemperatur zwischen ungefähr 650°C und 1250°C enthalten ist.

5. Verfahren nach einem der Ansprüche 1 bis 4, **dadurch gekennzeichnet, dass** der Halbleiterfilm (1) und/ oder der elektrisch isolierende Träger (2) Einfachschichten oder Mehrfachschichten sind.

6. Verfahren nach einem der Ansprüche 1 bis 5, **dadurch gekennzeichnet, dass** der elektrisch isolierende Träger (2) wenigstens im Bereich einer Grenzfläche mit dem Halbleiterfilm (1) aus Siliziumoxid und/ oder aus Siliziumnitrid ist.

7. Verfahren nach einem der Ansprüche 1 bis 6, **dadurch gekennzeichnet, dass** der Halbleiterfilm (1) gespannt ist.

8. Verfahren nach einem der Ansprüche 1 bis 7, **dadurch gekennzeichnet, dass** der Halbleiterfilm (1) auf Basis von Silizium und/ oder Germanium hergestellt ist.

9. Verfahren nach einem der Ansprüche 1 bis 8, **dadurch gekennzeichnet, dass** der Schritt der Bestrahlung und der Schritt des Temperns gleichzeitig durchgeführt werden.

10. Verfahren nach Anspruch 9, **dadurch gekennzeichnet, dass** der Schritt des Temperns innerhalb eines Elektronenmikroskops (17) erfolgt.

11. Verfahren nach einem der Ansprüche 1 bis 10, **dadurch gekennzeichnet, dass** der Schritt des Temperns unter neutraler oder reduzierender Atmosphäre erfolgt.

12. Verfahren nach einem der Ansprüche 1 bis 11, **dadurch gekennzeichnet, dass** die Bestrahlungszone (12) einen oder mehrere Teile (12a, 12b, 12c, 12d) umfasst, und wenn es mehrere Teile gibt, so sind letztere voneinander getrennt oder miteinander verbunden.

13. Verfahren nach Anspruch 12, **dadurch gekennzeichnet, dass** diese Teile punktförmig sind.

14. Verfahren nach einem der Ansprüche 1 bis 13, **dadurch gekennzeichnet, dass** der Elektronenstrahl (11) abtastend ist.

15. Verfahren nach einem der Ansprüche 1 bis 14, **dadurch gekennzeichnet, dass** der Film (1) eine volle Platte ist.

16. Verfahren nach einem der Ansprüche 1 bis 14, **dadurch gekennzeichnet, dass** der Film (21) mit wenigstens einem Motiv begrenzt ist.

17. Verfahren nach Anspruch 16, dass der Motivfilm (21) am Ende des Temperschritts zusätzlich zur Zone von Nanokristallen (13) wenigstens eine Elektrode (16.1, 16.2) realisiert, die dazu bestimmt ist, mit der Zone von Nanokristallen (13) zusammenzuwirken.

18. Verfahren nach Anspruch 17, **dadurch gekennzeichnet, dass** die Elektrode (16.1, 16.2) und die Zone von Nanokristallen (13) durch eine Trägerzone getrennt sind, die einen Tunnelkontakt (15.1, 15.2) bildet.

19. Verfahren nach einem der Ansprüche 17 oder 18, **dadurch gekennzeichnet, dass** die Struktur einer Source, einem Kanal und einem Drain eines Einzelelektronentransistors entspricht.
